# EUROPEAN PATENT APPLICATION

(11) **EP 1 221 357 A1**
(43) Date of publication of application: **10.07.2002**
(21) Application number: 01100366.2
(22) Date of filing: 05.01.2001
(51) Int. Cl.: B24C 1/00

(54) **Arrangement and method for cleaning a semiconductor device**

(71) Applicant: Infineon Technologies SC300 GmbH & Co. KG, 01099 Dresden (DE); MOTOROLA, INC., Schaumburg, IL 60196 (US); Infineon Technologies AG, 81669 München (DE)
(72) Inventor: Dougan, James, Round Rock Texas 78681 (US); Glashauser, Walter, 82041 Oberhaching (DE); Peschke, Matthias, 01458 Ottendorf-Okrilla (DE); Storbeck, Olaf, 01099 Dresden (DE); Vatel, Olivier, 01309 Dresden (DE)
(74) Representative: Fischer, Volker, Dipl.-Ing.

(57) **Abstract**

A semiconductor device (10) is cleaned using a carbon dioxide snow spray. Taking advantage of the cooling effect acting thereby, a semiconductor device backside (12) being contaminated by particles due to a manufacturing process like etching (101), that applies heat to said semiconductor device (10), is cooled, cleaned and processed, e.g. etched, coincidently. Post-processing like cool plate (102) and an extra clean process (103) can be skipped and time is saved. The arrangement comprises a showerhead-like nozzle (1) with multiple orifices (3) uniformly accessing the semiconductor surface and a clamp (4) for fixing the semiconductor device (10) inside the process chamber (20), which allows to treat the front- (11) as well as the backside (12) of said semiconductor device simultaneously with different processes.

## Description

This invention relates to an arrangement and a method for cleaning a semiconductor device.

Several methods have been developed to perform the cleaning of semiconductor devices, e.g. wafers. Commonly used techniques comprise chemical or physical cleaning in order to remove resists, films or contaminating particles from device surfaces. Chemical cleaning usually comprises alternating steps of applying solvents, rinses with megasonic waves, acids, hot gas in spin dryers and the like to the device depending on the manufacturing process that has been carried out prior to cleaning, while physical cleaning is particularly applied after etching or chemical mechanical polishing planarization processes, where scrubber cleaning, i.e. brush cleaning or jet scrubber, is often utilized.

A recent technique to clean semiconductor devices is the use of an aerosol sprayed upon the semiconductor device. Thereby, liquid or gaseous chemicals are led to nozzles under high pressure, which are then released into a low pressure gas medium. Due to the adiabatic expansion the phase of the chemical when exiting from the nozzle drops below the triple point in temperature and pressure, and an aerosol of liquid or solid particles forms, e.g. droplets. The size and phase of the particles or droplets as well as their velocity, which may be subsonic or supersonic, and the spray opening angle depend on the pressure inside the nozzle as well as the nozzle design. Chemicals commonly used are water or carbon dioxide, and the resulting ice particles or the carbon dioxide snow "sand-blast" the semiconductor device surface due to it's speed. The mechanical force impinging on the contaminating particles removes them from the surface while the ice or snow particles of the spray are sublimating to gas. The gas containing the particles is then led out of the low pressure chamber, where the cleaning process is carried out.

Several apparatus and methods have been proposed to clean semiconductor devices using jet spray nozzles exiting aerosols containing carbon dioxide. In US 6,066,032 a nozzle feeded with liquid carbon dioxide sprays a carbon dioxide aerosol onto the semiconductor device, while a carbon dioxide laser spots the same location on the device surface in order to outweigh the cooling by the cold jet. Contaminating particles are removed from the surface and are led out of the chamber with the sublimated carbon dioxide gas, or are filtered out in a special filter.

In US 5,810,942 cryogenic aerosols, including carbon dioxide, argon or nitrogen, are applied in order to clean a semiconductor device surface. Inside a cleaning chamber a nozzle, the direction of which can be varied, sprays the aerosol onto the device from aside. An aerodynamic aerosol chamber design then allows to lead out the gas dragging along the contaminating particles without the problem of recontamination.

Although the semiconductor device quality is improved using these new cleaning techniques, a circumstantial procedure of post-processing after basic manufacturing processes, e.g. etching, polishing, lithography and the like, remains. For example after an etching process of a wafer, the wafer first has to be cooled down on a cool-plate, and then it has to be cleaned in a cleaning chamber. This feature introduces additional waiting time, i.e. waiting time on the cool-plate, and manufacturing time as well as costs needed for the cleaning chamber. Moreover a loss of quality can be expected due to the many process steps that have to be performed until the following manufacturing process can be started.

It is therefore a primary object of the present invention to save the time needed for processing semiconductor devices, to improve their quality and to reduce costs in their manufacturing process.

The objective is solved by an arrangement and a method for cleaning a semiconductor device, comprising a clamp for fixing the semiconductor device thereby leaving a free space on the backside of said semiconductor device, a nozzle having at least one orifice, the nozzle having a distance from said semiconductor device when being clamped, for exiting an aerosol containing substantially solid or liquid carbon dioxide particles onto the backside of said semiconductor device, an arrangement of tubes inside said nozzle, for supplying said at least one orifice with a mixture containing liquid or gaseous carbon dioxide having a high pressure, and a high pressure source of said mixture containing liquid or gaseous carbon dioxide to provide said mixture to said at least one tube.

Using the arrangement according to the present invention the semiconductor device is held in such a position that it's frontside as well as its backside can be treated coincidentally by manufacturing processes, i.e. the cleaning of the semiconductor device backside and some other manufacturing process on the frontside. The common risk, that defects or contaminating particles remain on chucks and are transferred to the wafer backside can advantageously be opposed by the present invention using a spray jet containing carbon dioxide aerosol, which is blasted to the backside of the semiconductor device. The carbon dioxide particles, or droplets, form out of the expanding gas which is released from at least one orifice of a nozzle.

The nozzle is feeded with a gaseous or a liquid mixture from a high pressure gas bottle, a compressor or the like. This mixture can be pre-cooled, such that the exiting and expanding gas already falls below the triple point for building the aerosol particles. These particles move with high speed to the semiconductor device backside, where they mechanically impinge the contaminating particles and eventually remove them from the surface. By contacting the semiconductor device backside surface the cold aerosol particles withdraw heat from the semiconductor device and themselves eventually undergo a phase transition, i.e. they sublimate to gas. The process chamber comprises an exit to a vacuum pump into which the injected gas, i.e. originally the aerosol, can be sucked. The contaminating particles are dragged along with the moving gas exiting the process chamber.

By withdrawing heat from the semiconductor device it cools, a feature which can advantageously be utilized for compensating a process which heats the device, e.g. etching or a chemical or physical vapor deposition process (CVD, PVD). Taking the etching as an example, the arrangement and method according to the present invention can be implemented into an etch process chamber, where e.g. ions are moving towards the semiconductor device frontside in order to remove patterned areas from the surface layer, while the backside is coincidentally cooled and cleaned due to the present arrangement and method. Particles being removed from the device frontside by the etching process, moving to the backside and settling thereon are efficiently removed again by the cleaning process. Synchronously, the heating of the device to typically about 500°C thereby impeding etching anisotropy, is compensated by the cooling process due to the aerosol particles withdrawing heat from the device.

Cooling and cleaning the semiconductor device coincidentally the process steps following basic semiconductor manufacturing steps, i.e. post-processing steps, can be carried out together with the leading step in just one process. Time can be saved because different tasks can be carried out simultaneously, and equipment as well as support for the equipment can be reduced, because the same process chambers can be used for different tasks.

In a further aspect a multiple of the orifices constituting a showerhead-like nozzle is considered. The use of such a nozzle guarantees, that the surface of the semiconductor device is uniformly cooled and cleaned in order to reduce temperature gradients across the semiconductor device.

For minimizing these gradients the showerhead-like nozzle may either be moved across the surface when spraying, or it's extension can be chosen such as to cover the whole surface of the semiconductor device. In the latter aspect the clamp is configured such that a semiconductor device being clamped in is fully covered by the showerhead-like nozzle, or vice versa.

In a further aspect the control of the process is considered. In order to hold the temperature of the semiconductor device at a value, that best represents an optimized process quality, a sensor for measuring the temperature signals temperature values to a control unit. The control unit then adjusts the gas flow and pressure or even the distribution of orifices in order to increase or decrease the cooling by the aerosol for returning the device temperature to said optimal value, in case of deviations.

In another aspect a variable inclinition of the clamped semiconductor device with respect to the jet spray is considered. Depending on the surface structure, different angles of incidence of the aerosol particles onto the surface can be optimal to impinge the contaminating particle residing on the surface and to remove them. Moreover, a predominant gas stream develops across the surface, when the angle of incidence is different from 90°, which can be utilized to move contaminating particles into a preferred direction before sucking them into the vacuum exit, thus impeding recontamination elsewhere inside the chamber.

Further advantageous features, aspects and details of the invention are evident from the dependent claims.

The invention is now described with reference to embodiments taken in conjunction with the accompanying drawings, wherein
- figure 1: shows the post-processing steps after the process of etching according to state of the art.

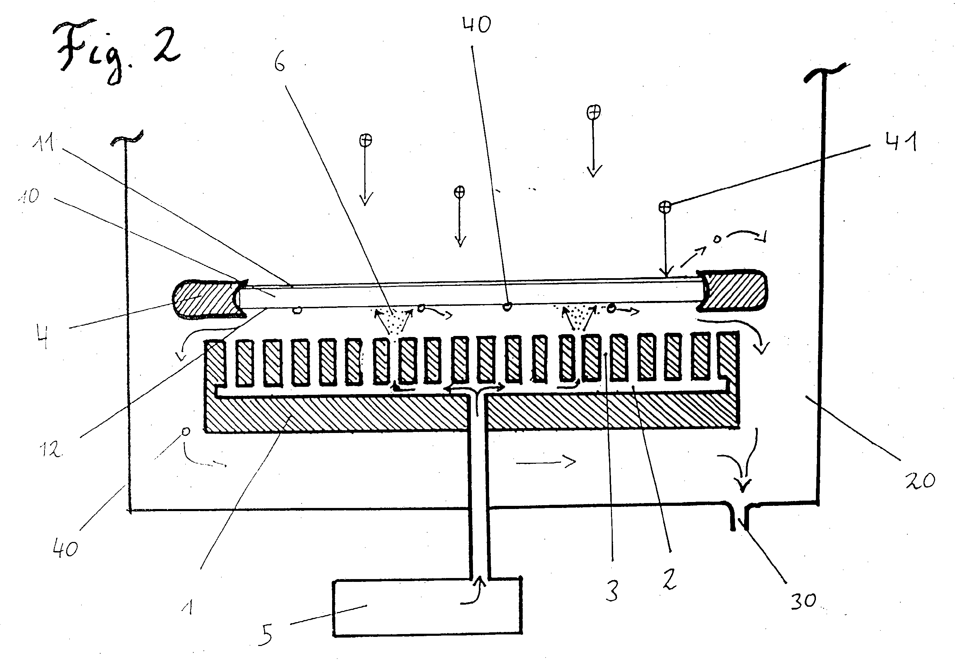

- figure 2: shows an embodiment according to the present invention implemented in an etch chamber.
- figure 3: shows an embodiment according to the method of the present invention with a control unit controlling the cooling and cleaning of a semiconductor device.

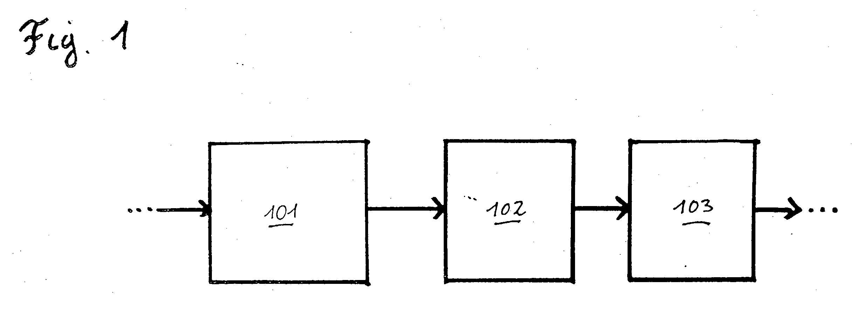

An embodiment of the present invention is given, which substitutes three different subsequent steps according to state of the art for etching a semiconductor wafer. As can be seen in figure 1 etching 101 the wafer is followed by cooling 102 the wafer on a cool-plate, since the wafer can have reached a temperature of up to 500°C, after which a cleaning 103 is carried out before the next step, e.g. a metrology step is started. In order to perform these three steps in just one step a nozzle 1 is mounted inside an etch process chamber 20 having a multiple of orifices 3 being connected by tubes 2 inside nozzle 1. The tubes 2 deliver gaseous or liquid carbon dioxide to the orifices 3 under high pressure originating from a carbon dioxide pressure gas cylinder or some other high pressure source of low temperature liquids. The orifices 3 of nozzle 1 define a plane and the exit directions of orifices 3 are arranged essentially parallel in order to provide a homogeneous spray jet.

The gas or liquid mixture is released from orifices 3 with high pressure into the process chamber 20, which has a comparatively low pressure leading to an efficient adiabatic expansion and thus a rapid cooling of the carbon dioxide. Depending on the original phase the carbon dioxide evaporates or desublimates and a liquid or solid aerosol 6 grows up thereby having a high speed.

A semiconductor wafer 10 clamped into wafer clamp 4 is mounted in a distance from the showerhead-like nozzle 1, such that semiconductor wafer 10 is substantially parallel to the plane defined by orifices 3. A distance between semiconductor 10 and the plane of orifices 3 is given such that the aerosol particles receive a suitable size when forming, and such that the individual spray jets merge into a homogeneous flow provided by the spray jet angles of the different orifices.

The wafer frontside 11 that is to be structured, is orientated towards an ion beam source inside the etch process chamber 20. Using for example a source and apparatus like in chemically assisted ion beam etching (CAIBE) Ar⁺ ions are bombing the wafer surface 11 and previously patterned surface areas are removed and sucked out of the chamber through a vacuum pump 30. Thereby, contaminating particles can move to the backside 12 of the semiconductor wafer 10 and deposit thereon.

Through mechanical impingement these contaminating particles 40 are removed again by the cold aerosol carbon dioxide spray 6, and are as well led out of the process chamber 20 through vacuum pump 30 by dragging these contaminating particles 40 along with the sublimated carbon dioxide gas that forms out of the carbon dioxide aerosol spray 6 when it heats up again. The carbon dioxide aerosol spray particles 6 withdraw this heat from the semiconductor wafer backside 12, so that semiconductor wafer 10 cools, while the semiconductor wafer frontside 11 is heated up by the bombing and reaction of the Ar⁺ ions with the surface layer.

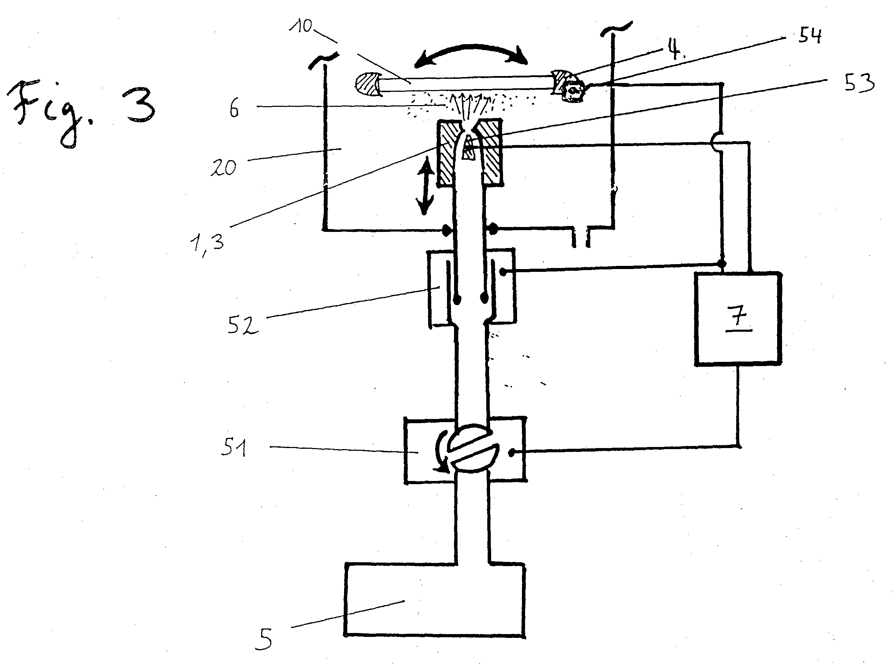

While the semiconductor wafer 10 is efficiently cleaned using this method, a coincident cooling can be implemented advantageously by using a control unit 7 for regulating the carbon dioxide spray intensity, which can be seen in figure 3. A sensor for measuring the temperature 54 resides near the wafer on the clamp and signals the temperature data to the control unit 7. There, deviations from an ideal temperature for anisotropic etching are recognized. The flow of gas or liquid from the source of pressure 5 to the nozzle 1 with the orifices 3 is then controlled or readjusted through a regulator 51 by a control unit 7. A spray regulator 53 is also controlled by control unit 7 in order to change spraying characteristics, e.g. spray angle, as well as gas or liquid throughput. Thus, the pressure between regulator 51 and spraying regulator 53 can be varied by control unit 7 in order to maintain the desired phase transitions. Thus, optimal characteristics of the aerosol spray 6 can be provided.

The spraying characteristics onto the wafer backside 12 can be varied by controlling a means for moving the nozzle 52 and a means for moving the clamp 4 in order to change the distance and the angle, which the spray jet takes with the wafer backside 12.

Thus, the intensity of the cooling of the wafer backside 12 can be controlled by control unit 7 in order to hold a desired temperature of the semiconductor wafer 10. Conventionally this has been solved by a chuck design comprising holes and channels on the chuck surface for cold helium gas cooling the semiconductor wafer 10, which is clamped electrostatically to the chuck. Unfortunately, wafer backside particle contamination required a post-process cleaning, and the need for cooled wafers for subsequent process steps required a post-process cooling. The present invention therefore saves efficiently time and equipment to manufacture a semiconductor wafer 10, e.g. during the etch process. Since less handling is needed and the cleaning is efficiently performed the product quality is significantly improved.

## Claims

1. Arrangement for cleaning a semiconductor device (10), comprising
- a clamp (4) for fixing the semiconductor device (10) leaving a free space on the backside (12) of said semiconductor device (10),
- a nozzle (1) having at least one orifice (3), the nozzle (1) having a distance from said semiconductor device (10) when being clamped, for exiting an aerosol (6) containing substantially solid or liquid carbon dioxide particles onto the backside (12) of said semiconductor device (10),
- at least one tube (2) inside said nozzle (1), for supplying said at least one orifice (3) with a mixture containing liquid or gaseous carbon dioxide having a high pressure,
- a high pressure source of said mixture (5) containing liquid or gaseous carbon dioxide to provide said mixture to said at least one tube.

2. Arrangement according to claim 1,
**characterized by**
a process chamber (20) which surrounds the nozzle (1) and the clamp (4), said process chamber (20) being designed to affect the surface of the frontside (11) of the semiconductor device (10).

3. Arrangement according to claim 2,
**characterized in that**
said process chamber (20) is designed to perform an etch process (101) or a chemical or physical vapor deposition process on the frontside (11) of said semiconductor device (10).

4. Arrangement according to anyone of claims 1 to 3,
**characterized in that**
said nozzle (1) comprises a pattern of a multiple of said orifices (3), each directed towards the clamped semiconductor device (10).

5. Arrangement according to anyone of claims 1 to 4,
**characterized in that**
said nozzle (1) has the extension of said semiconductor device (10) for uniformly accessing the surface of the semiconductor device (10) with said aerosol (6) containing substantially solid or liquid carbon dioxide particles.

6. Arrangement according to anyone of claims 2 to 5,
**characterized by**
a control unit (7) for controlling the gas flow and pressure through the nozzle (1), the control unit being connected to a sensor for measuring the temperature (54) of said semiconductor device (10).

7. Arrangement according to anyone of claims 1 to 6,
**characterized in that**
said clamp (4) is rotatable, such that the angle, that the surface of said clamped semiconductor device (10) has with the spray direction, can be varied.

8. Method for cleaning a semiconductor device (10), comprising the steps of
- fixing said semiconductor device (10) into a clamp (4) within a process chamber (20),
- leading a mixture containing liquid or gaseous carbon dioxide to a nozzle (1) which is arranged inside the process chamber (20), and
- releasing said carbon dioxide through at least one orifice (3) of said nozzle (1) with a high pressure towards the backside (12) of said semiconductor device (10), such that an aerosol (6) containing substantially solid carbon dioxide particles forms due to adiabatic expansion,
- leading sublimated carbon dioxide gas out of the process chamber (20).

9. Method according to claim 8,
**characterized in that**
said steps are performed while affecting the frontside (11) of the semiconductor device (10), preferrably by an etch process (101).

10. Method according to claim 9,
**characterized in that**
a control unit (7) controls at least one of the gas flow through a tube (2), the pressure of said mixture containing liquid or gaseous carbon dioxide, the distance of the nozzle (1) from the clamp (4) fixing the semiconductor device (10), and the selection of orifices (3) to be switched on in order to release carbon dioxide into said process chamber (20), in response to a temperature measurement of the semiconductor device (10) during said other semiconductor manufacturing step by means of a sensor for measuring temperature (54).
